# FASCICULE DE BREVET EUROPEEN

(11) **EP 4 402 798 B1**
(45) Date de publication et mention de la délivrance du brevet: **26.08.2026**
(21) Numéro de dépôt: 22769756.2
(22) Date de dépôt: 15.09.2022
(51) Int. Cl.: H03F 1/42, H03F 3/08, H03F 3/19, H04B 10/294, H01S 3/10, H01S 3/23, H01S 5/50, H01S 5/06, H01S 3/067, H01S 3/16, H01S 5/40

(54) **DISPOSITIF D'AMPLIFICATION LARGE BANDE PAR COMPOSANTS CONTROLES EN TEMPERATURE**
VORRICHTUNG ZUR BREITBANDIGEN VERSTÄRKUNG DURCH TEMPERATURGESTEUERTE KOMPONENTEN
DEVICE FOR BROADBAND AMPLIFICATION BY TEMPERATURE-CONTROLLED COMPONENTS

(30) Priorité: 17.09.2021 FR 2109804
(43) Date de publication de la demande: 24.07.2024
(73) Titulaire: L'Air Liquide, Société Anonyme pour l'Etude et l'Exploitation des Procédés Georges Claude, 75007 Paris (FR); Ecole Nationale d'Ingénieurs de Brest (ENIB), 29280 Plouzane (FR)
(72) Inventeur: GARDELEIN, Arnaud, 38360 SASSENAGE (FR); SHARAIHA, Ammar, 29280 PLOUZANE (FR); MOREL, Pascal, 29820 BOHARS (FR)
(74) Mandataire: Cabinet Novitech
(86) Numéro de dépôt international: PCT/EP2022/075707
(87) Numéro de publication internationale: WO 2023/041673

(56) Documents cités:
- US-A1- 2008 044 128
- US-B1- 6 400 864
- US-B2- 8 736 956

## Description

### DOMAINE DE L'INVENTION

L'invention a pour objet un dispositif d'amplification configuré pour amplifier un signal d'entrée.

### ETAT DE LA TECHNIQUE

Un amplificateur est un système électronique ou optoélectronique amplifiant un signal électrique ou optique. L'énergie nécessaire à l'amplification est tirée de l'alimentation électrique du système. Un amplificateur parfait ne déforme pas le signal d'entrée : sa sortie est une réplique exacte de l'entrée avec une puissance majorée.

Les amplificateurs sont utilisés dans quasiment tous les circuits en électronique et en optique : ils permettent d'élever la tension d'un signal électrique ou la puissance d'un signal optique vers un niveau exploitable par le reste du système, d'augmenter le courant de sortie d'un capteur pour en permettre la transmission sans interférences, de fournir une puissance maximale suffisante pour alimenter une charge comme une antenne radioélectrique ou une enceinte électroacoustique.

Il est connu qu'un amplificateur permet d'amplifier un signal pour une certaine bande passante. Dans le cas d'un circuit électrique, la bande passante définit une plage de fréquences dans laquelle le signal peut être amplifié. Dans le cas d'un circuit optique, la bande passante définit une plage de fréquences ou de longueurs d'onde dans laquelle le signal peut être amplifié, fréquence et longueur d'onde étant liées par l'équation $f = \frac{c}{λ}$, avec f définissant la fréquence de l'onde lumineuse, c définissant la célérité et λ définissant la longueur d'onde de l'onde lumineuse.

Chaque type d'amplificateur comprend une bande passante spécifique. Par exemple, un amplificateur à fibre dopée Erbium a une bande passante comprise entre 1530 et 1560 nm, tandis que les amplificateurs à effet de Raman ou les amplificateurs optiques à semiconducteurs peuvent avoir une bande passante de quelques dizaines de nanomètres, comprise entre 1280 et 1650 nm.

Un amplificateur idéal est linéaire sur toute sa bande passante. Plus particulièrement, la bande passante d'un amplificateur est définie par la bande passante à -3 dB. La bande passante à -3 dB d'un amplificateur est la plage de fréquences où le gain en tension ou en puissance de l'amplificateur est supérieur au gain maximum moins trois décibels. Ceci correspond à une division de la puissance fournie à la charge par deux. La bande passante à -3dB d'un amplificateur selon un des types d'amplificateurs mentionnés ci-avant correspond à environ 30 à 60 nm.

Il existe donc un besoin de pouvoir amplifier différents signaux d'entrée dont les plages de longueurs d'onde ou de fréquences peuvent être différentes sans nécessairement changer le nombre d'amplificateurs. Il existe un besoin, d'avoir un amplificateur permettant une amplification sur une large bande passante, par exemple une bande passant supérieure à 60 nm. Plus particulièrement, il existe un besoin pour une amplification continue sur une large plage de longueurs d'onde ou de fréquences pour augmenter le débit dans les systèmes de télécommunications optiques.

L'invention vise à fournir un dispositif pour répondre à ces besoins.

Le document US 2008/044128 A1 décrit un circuit à transmetteur photonique intégré (TXPICS) et un système de réseau de transport employant des TXPICS selon l'art antérieur.

### BREVE DESCRIPTION DE L'INVENTION

A cet effet, la présente invention a pour objet un dispositif d'amplification configuré pour amplifier un signal d'entrée, le dispositif comprenant :
- un démultiplexeur en longueurs d'onde ou en fréquence configuré pour démultiplexer le signal d'entrée en N signaux intermédiaires avec N supérieur ou égal à 2,
- un ensemble de N amplificateurs, chaque amplificateur étant configuré pour recevoir un des N signaux intermédiaires et générer un signal amplifié,
- un multiplexeur en longueurs d'onde ou en fréquences configuré pour recevoir et multiplexer les N signaux amplifiés en un signal de sortie,
dans lequel le dispositif d'amplification comprend un dispositif de contrôle de la température de l'ensemble des N amplificateurs, le dispositif de contrôle de la température étant configuré pour contrôler que la température d'au moins un amplificateur est différente de celle d'au moins un des autres amplificateurs.

Avantageusement, la température d'un amplificateur a un impact sur la position fréquentielle ou en longueurs d'onde de sa bande passante. De cette manière, si au moins un des amplificateurs a une température différente de celle d'au moins un des autres amplificateurs, le signal d'entrée peut être amplifié sur différentes plages de longueurs d'onde ou de fréquences.

Avantageusement en modifiant la température d'au moins un des N amplificateurs, sa bande passante est modifiée, en particulier la fréquence centrale de la bande passante de l'amplificateur.

Le fait de démultiplexer le signal d'entrée permet de former N différents signaux intermédiaires. Ces N différents signaux intermédiaires ont chacun une plage de longueurs d'onde ou de fréquences spécifique et différente. La combinaison des plages de longueurs d'onde ou de fréquences de chacun des N différents signaux intermédiaires reproduit au moins une partie ou l'intégralité de plage de longueurs d'onde ou de fréquences du signal d'entrée. Chacun de ces signaux intermédiaires peut être amplifié par un amplificateur spécifique étant adapté à la plage de longueurs d'onde ou de fréquences du signal intermédiaire à amplifier. L'ensemble des N signaux intermédiaires amplifiés sont multiplexés pour former un signal de sortie. Le signal de sortie est alors amplifié par rapport au signal d'entrée sur une plage de longueurs d'onde et de fréquences, et dans un mode de réalisation particulier, le signal de sortie est amplifié par rapport au signal d'entrée sur l'intégralité de la plage de longueurs d'onde ou de fréquences du signal d'entrée.

Avantageusement, le dispositif d'amplification peut également comprendre une ou plusieurs des caractéristiques ci-dessous, considérées individuellement ou selon toutes les combinaisons techniquement possibles :
- au moins un dispositif de refroidissement configuré pour refroidir les N amplificateurs à une température cryogénique, par exemple une température supérieure ou égale à 40 K et inférieure ou égale à 220 K ; et/ou
- le dispositif de contrôle de la température étant configuré pour que chacun des N amplificateurs soit à une température différente ; et/ou
- le dispositif de contrôle de la température est configuré pour que la différence de température entre au moins deux des N amplificateurs soit supérieure ou égale à 10K ; et/ou
- le dispositif de contrôle de la température est configuré de sorte que chacun des N amplificateurs soit à une température permettant un chevauchement successif des bandes passantes des N amplificateurs ; et/ou
- le dispositif de contrôle de la température comprend un dispositif de régulation de la température d'au moins un des N amplificateurs ; et/ou
- le démultiplexeur est configuré pour démultiplexer le signal d'entrée en N signaux intermédiaires ayant les largeurs de bandes en longueurs d'onde ou fréquence correspondant aux bandes passantes des N amplificateurs ; et/ou
- le dispositif de contrôle de la température comprend :
   - un barreau en un matériau ayant une conductivité thermique supérieure ou égale à 20 watts par mètre-kelvin sur lequel sont disposés les N amplificateurs,
   - un point froid disposé à un premier endroit du barreau, et
   - un dispositif de régulation de la température comprenant un capteur de température disposé à un deuxième endroit du barreau ; et/ou
- l'ensemble des N amplificateurs sont identiques ; et/ou
- les amplificateurs sont des amplificateurs optiques ; et/ou
- les amplificateurs sont des amplificateurs optiques à semi-conducteur ; et/ou
- le dispositif de contrôle de la température est configuré pour contrôler que la température de chacun des N amplificateurs soit supérieure ou égale à 40 K et inférieure ou égale à 220 K ; et/ou
- les amplificateurs sont des amplificateurs optoélectroniques ; et/ou
- les amplificateurs sont des amplificateurs électroniques.

### BREVE DESCRIPTION DES FIGURES

L'invention sera mieux comprise à la lumière de la description suivante qui n'est donnée qu'à titre indicatif et qui n'a pas pour but de limiter ladite invention, accompagnée des figures ci-dessous :
La figure 1 est une représentation graphique de bandes passantes de deux amplificateurs à fibre dopée Erbium,
La figure 2 est une représentation schématique d'un dispositif d' amplification selon l'invention,
La figure 3 est une représentation graphique de bandes passantes d'un amplificateur soumis à différentes températures,
La figure 4 est une représentation schématique d'un dispositif d'amplification comprenant un dispositif de régulation de la température des amplificateurs selon un premier mode de réalisation de l'invention,
La figure 5 est une représentation schématique d'un dispositif d'amplification comprenant un dispositif de régulation de la température des amplificateurs selon un second mode de réalisation de l'invention,
La figure 6 est une représentation schématique d'un dispositif d'amplification comprenant un dispositif de contrôle de la température des amplificateurs selon un premier mode de réalisation de l'invention,
La figure 7 est une représentation schématique d'un dispositif d'amplification comprenant un dispositif de régulation de la température des amplificateurs selon un second mode de réalisation de l'invention.

### DESCRIPTION DETAILLEE DE L'INVENTION

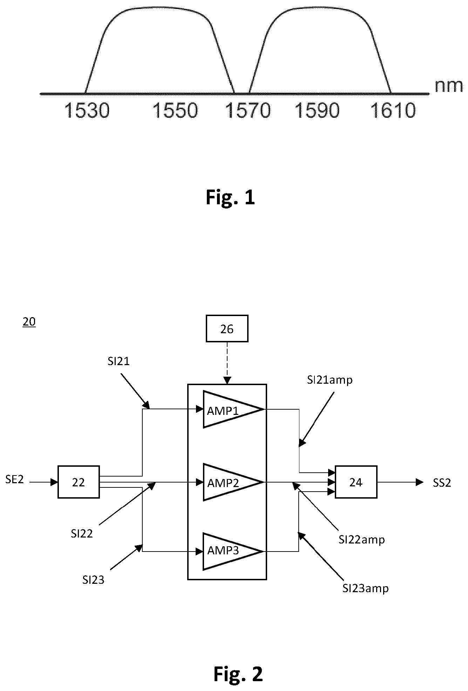

La figure 1 illustre les bandes passantes en longueurs d'onde de deux amplificateurs utilisant la technologie de la fibre dopée Erbium. Il est possible en agissant sur le dopant de décaler la bande passante des amplificateurs comme représenté sur la figure 1. Le premier amplificateur permet une amplification de signaux présentant des longueurs d'onde comprises entre 1535 et 1560 nm. Le second amplificateur AMP2, permet une amplification de signaux présentant des longueurs d'onde comprises entre 1575 et 1600 nm.

Le dispositif d'amplification qui utilise ce type d'amplificateur ne permet pas d'amplifier un signal d'entrée sur la plage de longueurs d'onde 1560 à 1575 nm.

L'invention porte sur un dispositif d'amplification configuré pour amplifier un signal d'entrée. Pour obtenir une amplification d'une partie ou de l'intégralité de la plage de longueurs d'onde ou de fréquences du signal d'entrée, il convient que l'intégralité des composantes de cette partie ou l'intégralité de la plage de longueurs d'onde ou de fréquences du signal d'entrée soient amplifiées.

L'invention vise à pouvoir élargir la plage de longueurs d'onde ou de fréquences sur laquelle un signal d'entrée peut être amplifiée.

Comme représenté sur la figure 2, un dispositif 20 selon l'invention comprenant :
- un démultiplexeur 22,
- un ensemble de N amplificateurs AMP1, AMP2, AMP3,
- un multiplexeur 24, et
- un dispositif de contrôle de la température 26 de l'ensemble des N amplificateurs.

Le démultiplexeur 22 est un démultiplexeur en longueurs d'onde ou en fréquences configuré pour démultiplexer un signal d'entrée SE2 en N signaux intermédiaires SI21, SI22, SI23 avec N supérieur ou égal à 2. Dans le cas particulier de la figure 2, le démultiplexeur divise le signal d'entrée SE2 en trois signaux intermédiaires SI21, SI22, SI23. Les trois signaux intermédiaires SI21, SI22, SI23 ayant chacun une plage de longueurs d'onde ou de fréquences différentes. La combinaison des plages de longueurs d'onde ou de fréquences des différents signaux intermédiaires SI21, SI22, SI23 reproduit au moins une partie de la plage de longueurs d'onde ou de fréquences du signal d'entrée SE2.

La bande passante d'un amplificateur est généralement limitée à quelques dizaines de nanomètres pour un amplificateur optique, ou comprise entre 100 kHz et plusieurs dizaines de GHz pour un amplificateur électronique, tel qu'un amplificateur électronique de télécommunication.

Concernant un amplificateur électronique, tel qu'un amplificateur électronique de télécommunication, seule la fréquence du signal est habituellement considérée.

Concernant la suite de la description, il sera plus particulièrement fait référence à un amplificateur optique. Toutefois, l'invention n'est pas limitée à un tel type d'amplificateur. Pour faciliter la compréhension, la description fera uniquement référence aux plages de valeurs en longueur d'onde des amplificateur AMP1, AMP2, AMP3. Le raisonnement est identique, si on prend en considération les pages de fréquence sur lesquelles les amplificateurs AMP1, AMP2, AMP3 fournissent une amplification. La fréquence du signal à amplifier est inversement proportionnelle à la longueur d'onde de ce dernier, comme précisé ci-dessus.

Le signal d'entrée SE2, dont la plage de longueurs d'onde est supérieure à quelques dizaines de nanomètres peut être divisé en N signaux intermédiaires SI21, SI22, SI23 à l'aide du démultiplexeur 22.

Avantageusement chacun des N signaux intermédiaires SI21, SI22, SI23 comprend une plage de longueurs d'onde. La plage de longueur d'onde des N signaux intermédiaires SI21, SI22, SI23 est de l'ordre de quelques dizaines de nanomètres. La plage de longueurs d'onde de chacun des N signaux intermédiaires SI21, SI22, SI23 est définie de manière à se superposer en tout ou en partie avec la bande passante de l'amplificateur AMP1, AMP2, AMP3 auquel le signal intermédiaire SI21, SI22, SI23 est transmis. De cette manière, chacun des N signaux intermédiaires SI21, SI22, SI23 transmis à un des N amplificateurs AMP1, AMP2, AMP3 peut être amplifié sur l'intégralité de sa plage de longueurs d'onde.

Dans un mode de réalisation particulier, la plage de longueurs d'onde d'un des signaux intermédiaires SI21, SI22, SI23 peut recouvrir en partie la plage de longueurs d'onde d'au moins un autre des signaux intermédiaires.

Le dispositif d'amplification comprend un ensemble de N amplificateurs AMP1, AMP2, AMP3. Chaque amplificateur reçoit un des N signaux intermédiaires SI21, SI22, SI23 et génère un signal amplifié SI21amp, SI22amp, SI23amp.

Chacun des N amplificateurs AMP1, AMP2, AMP3 a une bande passante BP1, BP2, BP3 respective. La bande passante BP1, BP2, BP3 de chacun des N amplificateurs est configurée de manière à pouvoir amplifier le signal intermédiaire SI21, SI22, SI23 reçu sur au moins une partie de la plage de longueurs d'onde du signal intermédiaire reçu. Préférentiellement, chacun des N amplificateurs AMP1, AMP2, AMP3 peut amplifier le signal intermédiaire SI21, SI22, SI23 reçu sur l'intégralité de la plage de longueurs d'onde du signal intermédiaire reçu.

Les inventeurs ont pu observer que la température d'un amplificateur influe sur sa bande passante, en particulier sur la position de cette bande passante. En modifiant la température d'un amplificateur, la position de la bande passante de l'amplificateur est modifiée et donc les bornes de la bande passante sont également modifiées. De cette manière, en modifiant la position fréquentielle ou en longueurs d'onde de chacun des amplificateurs du dispositif d'amplification, le dispositif d'amplification peut permettre une amplification du signal d'entrée sur une plage de longueurs d'onde plus importante.

Ainsi, les bandes passantes BP1, BP2, BP3 des N amplificateurs AMP1, AMP2, AMP3 sont définies par la température de chacun des N amplificateurs.

Au moins un des N amplificateurs est soumis à une température différente de celle des autres amplificateurs, définissant une bande passante différente de celles des autres amplificateurs.

Dans un mode de réalisation, chacun des N amplificateurs AMP1, AMP2, AMP3 est soumis à une température T1, T2, T3 différente, définissant des bandes passantes différentes BP1, BP2, BP3.

Chacun des N signaux intermédiaires SI21, SI22, SI23 comprend respectivement une plage de longueurs d'onde P1, P2, P3.

Le premier signal intermédiaire SI21, ayant une plage de longueurs d'onde P1, est transmis à un premier amplificateur AMP1. Le deuxième signal intermédiaire SI22, ayant une plage de longueurs d'onde P2, est transmis à un deuxième amplificateur AMP2. Le troisième signal intermédiaire SI23, ayant une plage de longueurs d'onde P3, est transmis à un troisième amplificateur AMP3.

La température T1 de l'amplificateur AMP1 est contrôlée pour que la bande passante BP1 soit configurée pour englober la plage de longueurs d'onde P1 et pour permettre d'amplifier le signal intermédiaire SI21 sur l'intégralité de sa plage de longueurs d'onde. La température T2 de l'amplificateur AMP2 est contrôlée pour que la bande passante BP2 soit configurée pour englober la plage de longueurs d'onde P2 et pour permettre d'amplifier le signal intermédiaire SI22 sur l'intégralité de sa plage de longueurs d'onde. La température T3 de l'amplificateur AMP3 est contrôlée pour que la bande passante BP3 soit configurée pour englober la plage de longueurs d'onde P3 et pour permettre d'amplifier le signal intermédiaire SI23 sur l'intégralité de sa plage de longueurs d'onde.

Dans la figure 2, le premier amplificateur AMP1 est conditionné à une température T1 permettant à l'amplificateur AMP1 d'avoir une bande passante correspondant à la bande passante BP1 du premier signal intermédiaire SI21. Le deuxième amplificateur AMP2 est conditionné à une température T2 permettant à l'amplificateur AMP2 d'avoir une bande passante correspondant à la bande passante BP2 du premier signal intermédiaire SI22. Le troisième amplificateur AMP3 est conditionné à une température T3 permettant à l'amplificateur AMP3 d'avoir une bande passante correspondant à la bande passante BP3 du premier signal intermédiaire SI23.

Les températures T1, T2 et T3 sont chacune différentes l'une de l'autre.

Dans un mode de réalisation particulier, la différence de température T1, T2, T3 entre au moins deux des N amplificateurs AMP1, AMP2, AMP3 est supérieure ou égale à 10K et inférieure ou égale à 50K.

Dans un mode de réalisation particulier, la différence de température T1, T2, T3 entre chaque paire d'amplificateurs, partageant un segment commun de bande passante, parmi les N amplificateurs AMP1, AMP2, AMP3 est supérieure ou égale à 10K et inférieure ou égale à 50K.

Dans un mode de réalisation particulier, la différence de température T1, T2, T3 entre chaque paire d'amplificateurs, ayant des bandes passantes adjacentes, parmi les N amplificateurs AMP1, AMP2, AMP3 est supérieure ou égale à 10K et inférieure ou égale à 50K.

Un premier amplificateur présente une première bande passante. Un second amplificateur présente une seconde bande passante. La borne supérieure de la première bande passante est inférieure à la borne inférieure de la seconde bande passante.

Un dispositif d'amplification comprend une pluralité d'amplificateurs, dont le premier et le second amplificateurs mentionnés ci-avant. L'écart est mesuré entre la borne supérieure de la première bande passante et la borne inférieure de la bande passante des différents autres amplificateurs du dispositifs d'amplification, pour les amplificateurs dont la borne inférieure de la bande passante est supérieure à la borne supérieure de la première bande passante.

Lorsque l'écart entre la bonne supérieure de la première passante et la borne inférieure de la seconde bande seconde passante est le plus faible des écarts mesurés, alors les première et seconde bande passante sont considérées adjacentes.

Dans un dispositif d'amplification 20 selon l'invention, il est possible que la température T1, T2, T3 d'au moins un des N amplificateurs AMP1, AMP2, AMP3 varie de 1K à 3K par rapport à la température cible désirée de l'amplificateur, tant que la température T1, T2, T3 de chacun des N amplificateurs AMP1, AMP2, AMP3 est différente.

Le dispositif d'amplification 20 comprend un multiplexeur 24 en longueurs d'onde. Le multiplexeur reçoit et multiplexe les N signaux amplifiés SI21amp, SI22amp, SI23amp, amplifiés respectivement par chacun des N amplificateurs AMP1, AMP2, AMP3.

Le multiplexeur 24 multiplexe les signaux intermédiaires amplifiés SI21amp, SI22amp, SI23amp afin de former un signal de sortie SS2.

Dans un mode de réalisation particulier, le signal de sortie SS2 présente la même plage de longueurs d'onde que le signal d'entrée SE2. Le signal de sortie SS2 est un signal correspondant à un signal, dont chacune des composantes de la plage de longueurs d'onde du signal d'entrée a été amplifiée.

Dans un mode de réalisation particulier, le signal de sortie SS2 présente une plage de longueurs d'onde formant une ou plusieurs parties de la plage de longueurs d'onde du signal d'entrée SE2. Chacune des composantes de la ou des parties de la plage du signal d'entrée SE2 formant le signal de sortie SS2 étant amplifiée.

Selon un mode de réalisation, le dispositif d'amplification 20 comprend en outre un dispositif de contrôle de la température 26 d'au moins un des N amplificateurs AMP1, AMP2, AMP3. Le dispositif de contrôle de la température 26 est configuré pour contrôler que l'au moins un des N amplificateurs AMP1, AMP2, AMP3 ait une température différente de celles des autres N amplificateurs AMP1, AMP2, AMP3.

Selon un mode de réalisation, le dispositif d'amplification 20 comprend un dispositif de contrôle de la température 26 de chacun des N amplificateurs AMP1, AMP2, AMP3. Le dispositif de contrôle de la température 26 est configuré pour contrôler que chacun des N amplificateurs AMP1, AMP2, AMP3 soit à une température différente T1, T2, T3.

Dans un mode de réalisation, un capteur de température est présent au niveau de chacun des N amplificateurs AMP1, AMP2, AMP3 de manière à mesurer leur température respective T1, T2, T3. Les températures T1, T2, T3 mesurées par les capteurs de températures sont transmises au dispositif de contrôle de la température 26. Le dispositif de contrôle de la température 26 peut ainsi contrôler qu'au moins la température mesurée de deux des N amplificateurs AMP1, AMP2, AMP3 est différente.

En fonction de l'étendue de la plage de longueurs d'onde du signal d'entrée SE2 et des bandes passantes BP1, BP2, BP3 des N amplificateurs AMP1, AMP2, AMP3, le signal d'entrée SE2 est divisé en N de signaux intermédiaires ayant chacun une plage de longueurs d'onde inférieure ou égale à la bande passante de l'amplificateur AMP1, AMP2, AMP3 auquel le signal intermédiaire SI21, SI22, SI23 est transmis.

Par exemple, pour une plage de longueurs d'onde d'un signal d'entrée de 150 nm, au moins cinq amplificateurs ayant respectivement une bande passante de 30 nm sont utilisés. Le signal d'entrée est divisé en au moins cinq signaux intermédiaires destinés à être transmis respectivement chacun à un des au moins cinq amplificateurs ayant une bande passante adaptée à une plage de longueurs d'onde du signal intermédiaire.

De cette manière, chacun des signaux intermédiaires SI21, SI22, SI23 peut être amplifié sur l'intégralité de sa plage P1, P2, P3 de longueurs d'onde. La combinaison des plages P1, P2, P3 de longueurs d'onde de chacun des signaux intermédiaires amplifiés SI21amp, SI22amp, SI23amp permet une amplification du signal d'entrée SE2 sur l'intégralité de la plage de longueurs d'onde du signal d'entrée SE2.

Le nombre N de signaux intermédiaires SI21, SI22, SI23 et d'amplificateurs AMP1, AMP2, AMP3 est conditionné par la largeur de la bande de longueurs d'onde du signal d'entrée.

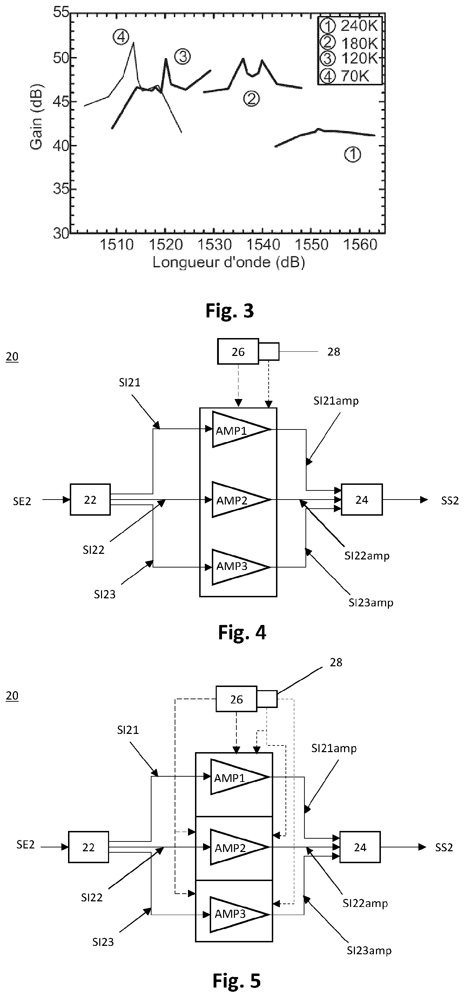

Comme illustré en figure 3, il a été observé que la température d'un amplificateur optique à semi-conducteurs a un impact sur la position en longueur d'onde de sa bande passante. De cette manière, si chacun des amplificateurs a une température différente, le signal d'entrée, divisé en N signaux intermédiaires, peut être amplifié sur différentes plages de longueurs d'onde.

Ainsi, deux amplificateurs identiques, à deux températures différentes, permettent d'amplifier un signal d'entrée démultiplexé sur deux plages différentes de longueurs d'onde.

Le dispositif d'amplification est modifiable et permet de garantir une amplification d'un signal d'entrée sur au moins une partie de sa plage de longueurs d'onde, même si la borne inférieure et/ou la borne supérieure de cette plage varie, en modifiant la température T1, T2, T3 des N amplificateurs AMP1, AMP2, AMP3.

Il peut être souhaitable d'éviter qu'une partie du signal d'entrée SE2 ne soit pas amplifiée, comme illustré en figure 1. Pour surmonter un tel problème, la régulation de la température d'au moins un des N amplificateurs permet d'assurer une amplification sur la plage de longueur d'onde 1560 à 1575 nm.

Préférentiellement, le dispositif de contrôle de la température 26 est configuré de sorte que chacun des N amplificateurs AMP1, AMP2, AMP3 soit à une température permettant un chevauchement successif des bandes passantes des N amplificateurs.

Avantageusement, un recouvrement des bandes passantes des N amplificateurs permet d'obtenir une amplification sur au moins une partie des longueurs d'onde composant le signal d'entrée SE2. Cela permet d'éviter qu'une plage de longueurs d'onde ne soit pas amplifiée, comme cela est illustré en figure 1, pour la plage de longueurs d'onde 1560 nm à 1575 nm.

En modifiant la température T1, T2, T3 des N amplificateurs AMP1, AMP2, AMP3, la position dans le domaine des longueurs d'onde de la bande passante BP1, BP2, BP3 de chacun des N amplificateurs est modifiée. La modification de la position dans le domaine des longueurs d'onde de la bande passante d'un amplificateur est obtenue en modifiant la longueur d'onde centrale de la bande passante d'un amplificateur, en agissant sur la température de l'amplificateur. De cette manière, en modifiant la position dans le domaine des longueurs d'onde des bandes passantes des N amplificateurs, la plage de longueurs d'onde sur laquelle un signal peut être amplifié est élargie, en contrôlant la température de N amplificateurs AMP1, AMP2, AMP3.

Dans un mode de réalisation particulier, le dispositif de contrôle de la température 26 est configuré pour que la différence de température T1, T2, T3 entre chacun des N amplificateurs AMP1, AMP2, AMP3 soit supérieure ou égale à 10K et inférieure ou égale à 50K. Une telle différence de température permet d'éviter un recouvrement trop important entre deux bandes passantes BP1, BP2, BP3 de deux des N amplificateurs AMP1, AMP2, AMP3. Avantageusement, en réduisant le recouvrement des bandes passantes des N amplificateurs AMP1, AMP2, AMP3, un nombre d'amplificateurs moins important est nécessaire pour amplifier un signal d'entrée sur au moins une partie de sa plage de longueurs d'onde.

Ainsi, préférentiellement, le recouvrement de la bande passante entre deux des N amplificateurs AMP1, AMP2, AMP3 est typiquement compris entre 1% et 20% de la bande passante, par exemple il peut être de l'ordre de 5 nm dans le cas d'un amplificateur optique ayant une bande passante de 50nm.

La figure 3 illustre la position en longueur d'onde de la bande passante d'un amplificateur, tel qu'un amplificateur optique à semi-conducteurs, selon différentes températures. Les expériences conduisant à cette invention ont montré que pour un amplificateur, le pic de gain se décale en fonction de la température, vers les longueurs d'onde plus faibles.

La figure 3 permet également de constater que plus la température de l'amplificateur est importante, plus la bande passante en longueurs d'onde est large. Il est visible que pour un amplificateur soumis à une température d'environ 70 K, la bande passante autour du pic de gain, près de 1510 nm est très réduite, de l'ordre de 5 à 10 nm. Tandis que dans des conditions de température proche de 240K, le pic de gain est proche de 1550 nm, et la largeur de la bande passante autour du pic de gain est plus importante, et peut être de l'ordre de 30 à 40 nm.

Toutefois, si la température d'un amplificateur est trop importante, le bruit généré lors de l'amplification est très important. Il est ainsi préférable de maintenir les amplificateurs à des températures inférieures ou égales à 350K pour que le bruit généré par l'amplification lors de l'amplification soit acceptable et ne pollue pas le signal de sortie.

Dans un mode de réalisation particulier, le dispositif de contrôle de la température 26 est configuré pour contrôler que la température T1, T2, T3 de chacun des N amplificateurs AMP1, AMP2, AMP3, refroidie par au moins un moyen de refroidissement, soit supérieure ou égale à 40K et inférieure ou égale à 350K, préférentiellement supérieure ou égale à 120K et inférieure ou égale à 220K, plus préférentiellement supérieure ou égale à 160K et inférieure ou égale à 220K.

Avantageusement, lorsque la température d'un amplificateur optique à semi-conducteur est comprise entre 40K et 220K, la bande passante des amplificateurs sur laquelle un signal intermédiaire peut être amplifié est comprise entre 5 nm et 60 nm, et typiquement comprise entre 20 nm et 40 nm pour un amplificateur optique à semi-conducteurs entre 120K et 220K.

Un dispositif de refroidissement est utilisé pour maintenir les N amplificateurs à des températures inférieures ou égales à 350K. Le dispositif de refroidissement est contrôlé par un dispositif de régulation 28 de la température (voir figures 4 à 7).

Dans un mode de réalisation particulier, le dispositif de refroidissement est un dispositif de refroidissement passif, détaillé par la suite lors de la description de la figure 4.

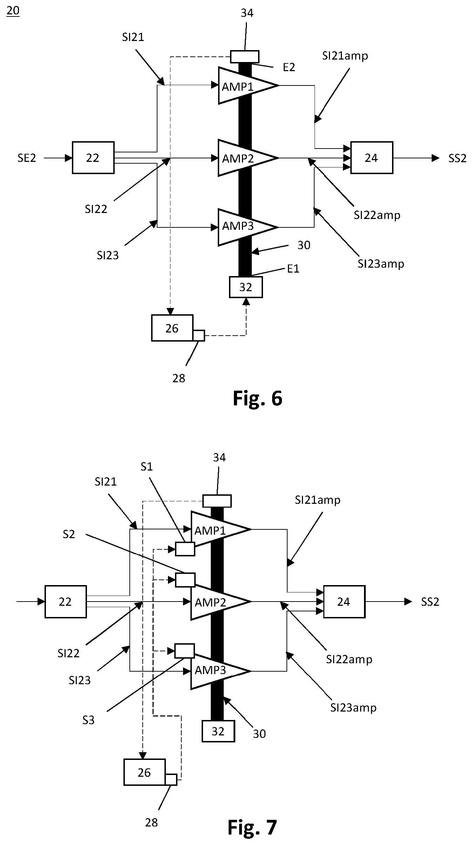

Dans un autre mode de réalisation particulier, le dispositif de refroidissement est un dispositif de refroidissement cryogénique. Un mode de réalisation de l'invention comprenant un tel dispositif de refroidissement est illustré en figures 6 et 7 et décrit par la suite.

La régulation en température de l'un des N amplificateurs AMP1, AMP2, AMP3 permet de de réguler sa bande passante. En modifiant la température de l'amplificateur dont la température est régulée, la bande passant sur laquelle l'amplificateur peut amplifier un signal est également modifiée.

Ainsi, selon un mode de réalisation, le dispositif d'amplification selon l'invention permet de contrôler et/ou modifier la température d'au moins un des N amplificateurs AMP1, AMP2, AMP3, en vue de contrôler et/ou modifier sa bande passante.

Par exemple, un dispositif d'amplification selon l'invention peut comprendre un amplificateur AMPamb dont la température n'est pas régulable et au moins deux amplificateurs AMP1, AMP2 dont la température est régulable à l'aide du dispositif de régulation 28 de la température. L'amplificateur AMPamb a une température équivalente est à la température ambiante Tamb de l'emplacement où est disposé le dispositif d'amplification. Le premier amplificateur AMP1 ayant une température régulable est refroidi à une température T1. Le second amplificateur AMP2 ayant une température régulable est refroidi à une température T2.

Selon cet exemple, dans un premier mode de régulation, le dispositif de contrôle de la température 26 peut contrôler uniquement si la température T1 du premier amplificateur AMP1 est différente des températures T2 et Tamb, afin de de fournir à l'amplificateur AMP1 une bande passante différente du second amplificateur AMP2 et de l'amplificateur AMPamb.

Si la température T1 du premier amplificateur AMP1 est égale à une des températures T2 ou Tamb, le dispositif de régulation 28 de la température peut modifier la température T1 du premier amplificateur AMP1, à l'aide d'un dispositif de refroidissement, pour être différente des températures Tamb et T2, afin que chacun l'amplificateur ait une bande passante différente des amplificateurs AMP2 et AMPamb.

Selon cet exemple, dans un second mode de réalisation, le dispositif de contrôle de la température 26 peut contrôler la température T1 du premier amplificateur AMP1 est différente des températures T2 et Tamb, et que la température T2 du second amplificateur AMP2 est différente des températures T1 et Tamb.

Si la température T1 du premier amplificateur AMP1 est égale à une des températures T2 ou Tamb, le dispositif de régulation 28 de la température peut modifier la température T1 du premier amplificateur AMP1, à l'aide d'un dispositif de refroidissement, pour être différente des températures Tamb et T2, afin que chacun des amplificateurs ait une bande passante différente.

De la même manière, si la température T2 du second amplificateur AMP2 est égale à une des températures T1 ou Tamb, le dispositif de régulation 28 de la température peut modifier la température T2 du second amplificateur AMP2, à l'aide d'un dispositif de refroidissement, pour être différente des températures Tamb et T1, afin que chacun des amplificateurs ait une bande passante différente.

Selon un autre mode de réalisation, le dispositif d'amplification selon l'invention permet de contrôler et/ou modifier la température d'au moins un ou chacun des N amplificateurs AMP1, AMP2, AMP3, en vue de contrôler et/ou modifier leur bande passante respectives.

Dans un mode de réalisation particulier, l'ensemble des N amplificateurs AMP1, AMP2, AMP3 sont identiques. Avantageusement, comme illustré en figure 3, différentes bandes passantes BP1, BP2, BP3 peuvent être obtenues par un même amplificateur en fonction de sa température.

Il est considéré que des amplificateurs sont identiques s'ils ont la même nature et la même largeur de bande passante, et plus particulièrement la même bande passante à la même température.

Par conséquent, un dispositif d'amplification 20 selon l'invention peut être constitué de N amplificateurs AMP1, AMP2, AMP3 identiques et permettre une amplification sur au moins une partie de la plage de longueurs d'onde du signal d'entrée en régulant la température d'au moins un des N amplificateurs.

Dans un mode de réalisation particulier, le dispositif de contrôle de la température comprend un dispositif de régulation de la température d'au moins un des N amplificateurs.

La figure 4 illustre un schéma électrique ou optique reprenant l'ensemble des caractéristiques illustrées en figure 2. Le dispositif d'amplification 20 selon l'invention, illustré en figure 4, illustre un dispositif de contrôle de la température 26 comprenant un dispositif de régulation de la température 28 d'au moins un des N amplificateurs AMP1, AMP2, AMP3.

Préférentiellement, pour garantir une différence de température entre deux des N amplificateurs AMP1, AMP2, AMP3, il est avantageux de pouvoir réguler la température d'au moins un de ces deux amplificateurs.

Dans un mode de réalisation préférentiel, chacun des N amplificateurs est régulé indépendamment des autres en température par le dispositif de régulation de la température 28, comme cela est illustré en figure 5.

La figure 6 illustre un mode de réalisation particulier du dispositif de contrôle de température 26. Le dispositif de contrôle de la température 26 peut comprendre :
- un barreau 30 en un matériau ayant une conductivité thermique élevée sur lequel sont disposés les N amplificateurs (dans le cas de la figure 6, trois amplificateurs AMP1, AMP2 et AMP3 sont illustrés),
- un point froid 32 disposé à un premier endroit E1 du barreau 30, et
- un dispositif de régulation 28 de la température comprenant un capteur de température 34 disposé à un deuxième endroit E2 du barreau.

A la place du point E2, situé sur le barreau, le capteur de température peut être situé au niveau du point froid 32 ou au niveau d'un des N amplificateurs AMP1, AMP2 et AMP3.

Préférentiellement, le barreau 30 a une conductivité thermique supérieure ou égale à 20 watts par mètre-kelvin. La température à différents emplacements du barreau 30 est différente.

Dans un mode de réalisation particulier, le barreau 30 est en cuivre.

Un tel dispositif d'amplification 20 comprenant un barreau en matériau ayant une conductivité thermique élevée et la présence d'un point froid 32 permet de créer un gradient de température entre le premier endroit où est disposée la source froide 32 et une extrémité du barreau 30.

La température des N amplificateurs disposés sur le barreau 30 est conditionnée par leur emplacement sur le barreau 30.

Le point froid 32 correspond à un dispositif de refroidissement configuré pour refroidir le barreau 30 à un endroit particulier de ce barreau 30 correspondant au premier endroit E1.

Dans un mode de réalisation particulier, le dispositif de refroidissement utilisé est un refroidisseur cryogénique.

De cette manière, les amplificateurs disposés les plus proches du point froid 32 présentent une température plus froide que les amplificateurs les plus éloignés du point droit 32.

Le point froid 32 est préférentiellement positionné à une extrémité du barreau 30 pour maximiser le gradient de température entre une première extrémité et une seconde extrémité du barreau 30.

Avec un tel gradient de température, le positionnement des N amplificateurs est important pour permettre audit amplificateur d'être à la température cible désirée.

Le positionnement d'un capteur de température 34 à un second endroit E2 du barreau 30 permet de déterminer la température du barreau 30 à ce second endroit E2. Le barreau étant dans un matériau conducteur, il peut être déterminé, à partir de la mesure du capteur de température 34, au moins de façon approximative la température en chaque point du barreau et plus particulièrement aux positions où sont disposés les N amplificateurs AMP1, AMP2 et AMP3.

Ainsi, à partir de la mesure de la température audit second endroit E2 du barreau 30, le dispositif de contrôle de la température 26 peut déterminer si la température des N amplificateurs AMP1, AMP2 et AMP3 correspond à une température cible désirée. Si la température T1, T2, T3 d'au moins un des N amplificateurs AMP1, AMP2 et AMP3 est différente de la température cible désirée, le dispositif de contrôle de température 26 commande le dispositif de régulation de la température 28 pour réguler la température du point froid 32 et par conséquent la température des N amplificateurs.

Dans un tel mode de réalisation, la température de chacun des N amplificateurs AMP1, AMP2, AMP3 peut être connue à l'aide d'un unique capteur de température de température 34.

Le capteur de température 34 peut être positionné au niveau de la source froide, au niveau de l'un des N amplificateurs AMP1, AMP2, AMP3 ou encore en n'importe quel point du barreau 30.

Pour utiliser un seul capteur de température, il est toutefois nécessaire de connaitre les paramètres suivants :
- la température au niveau du point froid 32 ou d'un point du barreau 30 ou au niveau d'un des N amplificateurs AMP1, AMP2, AMP3,
- la conductivité thermique du barreau 30,
- le positionnement des N amplificateurs AMP1, AMP2, AMP3 disposés sur le barreau 30, et
- la dissipation thermique de chacun des N amplificateurs AMP1, AMP2, AMP3.

A partir de ces paramètres, le dispositif de contrôle de la température peut déterminer la température 26 de de l'ensemble des N amplificateurs AMP1, AMP2, AMP3. De cette manière, le dispositif de contrôle de la température au niveau d'au moins deux des N amplificateurs est différente.

Selon un mode de réalisation, la température d'un amplificateur peut être dérivée à partir de la tension alimentant l'amplificateur. Plus particulièrement, dans un tel mode de réalisation particulier, la mesure de résistance à 4 fils est considérée pour déterminer la tension alimentant l'amplificateurs.

Quand la température est dérivée à partir de la tension alimentant l'amplificateur, il est nécessaire de réaliser un étalonnage permettant d'obtenir la relation entre tension et température. Dans le cadre de l'étalonnage, le courant et la puissance optique fournis sont maîtrisés.

Dans la méthode de mesure de résistance à 4 fils, la connexion à quatre fils est utilisée. Deux des quatre fils sont utilisés pour fournir le courant d'alimentation à l'amplificateur, et les deux autres fils sont utilisés pour mesurer la tension à travers l'amplificateur.

Dans un autre mode de réalisation illustré en figure 7, le dispositif de contrôle de la température 26 contrôle de manière indépendante la température T1, T2, T3 de chacun des N amplificateurs AMP1, AMP2 et AMP3. Si un des N amplificateurs n'est pas à une température cible désirée, le dispositif de régulation de la température régule de manière indépendante la température de cet amplificateur.

Chacun des N amplificateurs AMP1, AMP2 et AMP3 est associé à une source thermique additionnelle S1, S2, S3 respective. Chacune des N sources thermiques additionnelles S1, S2, S3 est configurée pour réguler individuellement la température d'un des N amplificateurs.

Dans un mode de réalisation particulier, chacune des N sources thermiques additionnelles sont des modules Peltier.

Le mode de réalisation, illustré en figure 7, est similaire à la configuration illustrée en figure 6, le dispositif de régulation de la température 28 est toutefois différent. Le dispositif de régulation de la température 28 ne régule plus la température du point froid 32 mais régule la température des sources thermiques additionnelles S1, S2 et S3.

Dans un tel mode de réalisation, pour obtenir la température de chacun des N amplificateurs AMP1, AMP2, AMP3 il est nécessaire qu'un capteur de température 34 soit positionné au niveau de chacune des N sources thermiques additionnelles S1, S2, S3 ou au niveau de chacun des N amplificateur AMP1, AMP2, AMP3 réchauffés ou refroidis par l'une des N sources thermiques additionnelles S1, S2, S3.

Le dispositif d'amplification 20 selon l'invention peut être utilisé pour différents types d'amplificateurs permettant d'amplifier un signal d'entrée électrique ou optique.

Dans un mode de réalisation particulier, le dispositif d'amplification 20 comprend N amplificateurs AMP1, AMP2 et AMP3 qui sont des amplificateurs optiques.

Dans un mode de réalisation particulier, le dispositif d'amplification 20 comprend N amplificateurs AMP1, AMP2 et AMP3 qui sont des amplificateurs optiques à semi-conducteurs.

Dans un mode de réalisation particulier, le dispositif d'amplification 20 comprend N amplificateurs AMP1, AMP2 et AMP3 qui sont des amplificateurs optoélectroniques.

Dans un mode de réalisation particulier, le dispositif d'amplification 20 comprend N amplificateurs AMP1, AMP2 et AMP3 qui sont des amplificateurs électroniques.

Les amplificateurs électroniques comprennent des composant passifs ayant des propriétés spécifiques qui varient en fonction de la température à laquelle le composant passif est soumis. Les variations des propriétés de ces composants passifs induit une variation de la bande passante sur laquelle un signal peut être amplifié par l'amplificateur.

Plus particulièrement, les amplificateurs électroniques sont composés de matériaux, tel que du silicium. Les caractéristiques des amplificateurs, comme la bande passante sur laquelle un signal peut être amplifié, sont dépendants des paramètres physiques intrinsèques de l'amplificateur. Ces paramètres intrinsèques sont influencés par a température à laquelle est soumis l'amplificateur. Par exemple, la température a un impact sur la mobilité des électrons dans le cadre des matériaux dédiés à leur mobilité au sein de l'amplificateur.

L'invention a été décrite ci-dessus avec l'aide de modes de réalisation présentés sur les figures, sans limitation du concept inventif général.

Bien d'autres modifications et variations se suggèrent d'elles-mêmes à l'homme du métier, après réflexion sur les différents modes de réalisation illustrés dans cette demande.

Ces modes de réalisation sont donnés à titre d'exemple et ne sont pas destinés à limiter la portée de l'invention, qui est déterminée exclusivement par les revendications ci-dessous.

Dans les revendications, le mot « comprenant » n'exclut pas d'autres éléments ou étapes, et l'utilisation de l'article indéfini « un » ou « une » n'exclut pas une pluralité. Le simple fait que différentes caractéristiques sont énumérées en revendications mutuellement dépendantes n'indique pas qu'une combinaison de ces caractéristiques ne puisse être avantageusement utilisée. Enfin, toute référence utilisée dans les revendications ne doit pas être interprétée comme une limitation de la portée de l'invention.

## Revendications

1. Dispositif d'amplification (20) configuré pour amplifier un signal d'entrée (SE2), le dispositif comprenant :
- un démultiplexeur (22) en longueurs d'onde ou en fréquence configuré pour démultiplexer le signal d'entrée (SE2) en N signaux intermédiaires (SI21, SI22, SI23) avec N supérieur ou égal à 2,
- un ensemble de N amplificateurs optiques ou optiques à semi-conducteur (AMP1, AMP2, AMP3), chaque amplificateur étant configuré pour recevoir un des N signaux intermédiaires (SI21, SI22, SI23) et générer un signal amplifié (SI21amp, SI22amp, SI23amp),
- un multiplexeur (24) en longueurs d'onde ou en fréquences configuré pour recevoir et multiplexer les N signaux amplifiés (SI21amp, SI22amp, SI23amp) en un signal de sortie (SS2),
dans lequel le dispositif d'amplification (20) comprend un dispositif de régulation de la température (26) de l'ensemble des N amplificateurs (AMP1, AMP2, AMP3), le dispositif de régulation de la température (26) étant configuré pour réguler la température d'au moins un amplificateur est différente de celle d'au moins un des autres amplificateurs, et ce de manière indépendante pour chacun des N amplificateurs.

2. Dispositif d'amplification selon la revendication 1, dans lequel le dispositif d'amplification (20) comprend au moins un dispositif de refroidissement configuré pour refroidir les N amplificateurs à une température cryogénique, par exemple une température supérieure ou égale à 40 K et inférieure ou égale à 220 K.

3. Dispositif d'amplification selon la revendication 1 ou 2, dans lequel le dispositif de contrôle de la température (26) étant configuré pour que chacun des N amplificateurs (AMP1, AMP2, AMP3) soit à une température différente (T1, T2, T3).

4. Dispositif d'amplification selon l'une des revendications précédentes dans lequel le dispositif de contrôle de la température est configuré pour que la différence de température entre au moins deux des N amplificateurs (AMP1, AMP2, AMP3) soit supérieure ou égale à 10K.

5. Dispositif d'amplification selon l'une des revendications précédentes, dans lequel le dispositif de contrôle de la température (26) est configuré de sorte que chacun des N amplificateurs (AMP1, AMP2, AMP3) soit à une température (T1, T2, T3) permettant un chevauchement successif des bandes passantes (BP1, BP2, BP3) des N amplificateurs (AMP1, AMP2, AMP3).

6. Dispositif d'amplification selon l'une des revendications précédentes, dans lequel le dispositif de contrôle de la température (26) comprend un dispositif de régulation de la température (28) d'au moins un des N amplificateurs (AMP1, AMP2, AMP3).

7. Dispositif d'amplification selon l'une des revendications précédentes, dans lequel le démultiplexeur (22) est configuré pour démultiplexer le signal d'entrée (SE2) en N signaux intermédiaires (SI21, SI22, SI23) ayant les largeurs de bandes en longueurs d'onde ou fréquence correspondant aux bandes passantes (BP1, BP2, BP3) des N amplificateurs (AMP1, AMP2, AMP3).

8. Dispositif d'amplification selon l'une des revendications précédentes, dans lequel le dispositif de contrôle de la température (26) comprend :
- un barreau (30) en un matériau ayant une conductivité thermique supérieure ou égale à 20 watts par mètre-kelvin sur lequel sont disposés les N amplificateurs,
- un point froid (32) disposé à un premier endroit du barreau, et
- un dispositif de régulation de la température (28) comprenant un capteur de température (34) disposé à un deuxième endroit du barreau (30).

9. Dispositif d' amplification selon l'une des revendications précédentes, dans lequel l'ensemble des N amplificateurs (AMP1, AMP2, AMP3) sont identiques.

10. Dispositif d'amplification selon l'une des revendications précédentes, dans lequel les amplificateurs (AMP1, AMP2, AMP3) sont des amplificateurs optiques.

11. Dispositif d'amplification selon la revendication précédente, dans lequel les amplificateurs (AMP1, AMP2, AMP3) sont des amplificateurs optiques à semi-conducteurs.

12. Dispositif d'amplification selon l'une des revendications précédentes, dans lequel le dispositif de contrôle de la température (26) est configuré pour contrôler que la température (T1, T2, T3) de chacun des N amplificateurs (AMP1, AMP2, AMP3) soit supérieure ou égale à 40 K et inférieure ou égale à 220 K.

## Patentansprüche

1. Eine Verstärkungsvorrichtung (20), die konfiguriert ist, um ein Eingangssignal (SE2) zu verstärken, wobei die Vorrichtung umfasst:
- einen Wellenlängen- oder Frequenz-Demultiplexer (22), der konfiguriert ist, um das Eingangssignal (SE2) in N Zwischensignale (S121, S122, S123) zu demultiplexen, wobei N größer oder gleich 2 ist,
- einen Satz von N optischen oder optischen Halbleiterverstärkern (AMP1, AMP2, AMP3), wobei jeder Verstärker konfiguriert ist, um eines der N Zwischensignale (SI21, S122, S123) zu empfangen und ein verstärktes Signal (SI21amp, SI22amp, SI23amp) zu erzeugen,
- einen Wellenlängen- oder Frequenz-Multiplexer (24), der konfiguriert ist, um die N verstärkten Signale (SI21amp, SI22amp, SI23amp) zu empfangen und zu einem Ausgangssignal (SS2) zu multiplexen,
wobei die Verstärkungsvorrichtung (20) eine Temperaturregelungsvorrichtung (26) für den Satz von N Verstärkern (AMP1, AMP2, AMP3) umfasst, wobei die Temperaturregelungsvorrichtung (26) konfiguriert ist, um die Temperatur von mindestens einem Verstärker so zu regeln, dass sie sich von der von mindestens einem der anderen Verstärker unterscheidet, und zwar unabhängig für jeden der N Verstärker.

2. Die Verstärkungsvorrichtung nach Anspruch 1, wobei die Verstärkungsvorrichtung (20) mindestens eine Kühlvorrichtung umfasst, die konfiguriert ist, um die N Verstärker auf eine kryogene Temperatur zu kühlen, beispielsweise eine Temperatur, die größer oder gleich 40 K und kleiner oder gleich 220 K ist.

3. Die Verstärkungsvorrichtung nach Anspruch 1 oder 2, wobei die Temperatursteuervorrichtung (26) so konfiguriert ist, dass jeder der N Verstärker (AMP1, AMP2, AMP3) eine unterschiedliche Temperatur (T1, T2, T3) aufweist.

4. Die Verstärkungsvorrichtung nach einem der vorhergehenden Ansprüche, wobei die Temperatursteuervorrichtung so konfiguriert ist, dass der Temperaturunterschied zwischen mindestens zwei der N Verstärker (AMP1, AMP2, AMP3) größer oder gleich 10 K ist.

5. Die Verstärkungsvorrichtung nach einem der vorhergehenden Ansprüche, wobei die Temperatursteuervorrichtung (26) so konfiguriert ist, dass sich jeder der N Verstärker (AMP1, AMP2, AMP3) auf einer Temperatur (T1, T2, T3) befindet, die eine sukzessive Überlappung der Durchlassbänder (BP1, BP2, BP3) der N Verstärker (AMP1, AMP2, AMP3) ermöglicht.

6. Die Verstärkungsvorrichtung nach einem der vorhergehenden Ansprüche, wobei die Temperatursteuervorrichtung (26) eine Temperaturregelungsvorrichtung (28) für mindestens einen der N Verstärker (AMP1, AMP2, AMP3) umfasst.

7. Die Verstärkungsvorrichtung nach einem der vorhergehenden Ansprüche, wobei der Demultiplexer (22) konfiguriert ist, um das Eingangssignal (SE2) in N Zwischensignale (S121, S122, S123) zu demultiplexen, die Bandbreiten in Wellenlänge oder Frequenz aufweisen, die den Durchlassbändern (BP1, BP2, BP3) der N Verstärker (AMP1, AMP2, AMP3) entsprechen.

8. Die Verstärkungsvorrichtung nach einem der vorhergehenden Ansprüche, wobei die Temperatursteuervorrichtung (26) umfasst:
- einen Stab (30) aus einem Material mit einer Wärmeleitfähigkeit von mehr als oder gleich 20 Watt pro Meter-Kelvin, auf dem die N Verstärker angeordnet sind,
- einen Kaltpunkt (32), der an einer ersten Stelle des Stabes angeordnet ist, und
- eine Temperaturregelungsvorrichtung (28), die einen Temperatursensor (34) umfasst, der an einer zweiten Stelle des Stabes (30) angeordnet ist.

9. Die Verstärkungsvorrichtung nach einem der vorhergehenden Ansprüche, wobei der Satz von N Verstärkern (AMP1, AMP2, AMP3) identisch ist.

10. Die Verstärkungsvorrichtung nach einem der vorhergehenden Ansprüche, wobei die Verstärker (AMP1, AMP2, AMP3) optische Verstärker sind.

11. Die Verstärkungsvorrichtung nach dem vorhergehenden Anspruch, wobei die Verstärker (AMP1, AMP2, AMP3) optische Halbleiterverstärker sind.

12. Die Verstärkungsvorrichtung nach einem der vorhergehenden Ansprüche, wobei die Temperatursteuervorrichtung (26) konfiguriert ist, um zu steuern, dass die Temperatur (T1, T2, T3) jedes der N Verstärker (AMP1, AMP2, AMP3) größer oder gleich 40 K und kleiner oder gleich 220 K ist.

## Claims

1. An amplification device (20) configured to amplify an input signal (SE2), the device comprising:
- a wavelength or frequency demultiplexer (22) configured to demultiplex the input signal (SE2) into N intermediate signals (S121, S122, S123) with N being greater than or equal to 2,
- a set of N optical or semiconductor optical amplifiers (AMP1, AMP2, AMP3), each amplifier being configured to receive one of the N intermediate signals (S121, S122, S123) and to generate an amplified signal (SI21amp, SI22amp, SI23amp),
- a wavelength or frequency multiplexer (24) configured to receive and multiplex the N amplified signals (SI21amp, SI22amp, SI23amp) into an output signal (SS2),
wherein the amplification device (20) comprises a temperature regulation device (26) for the set of N amplifiers (AMP1, AMP2, AMP3), the temperature regulation device (26) being configured to regulate the temperature of at least one amplifier to be different from that of at least one of the other amplifiers, and this independently for each of the N amplifiers.

2. The amplification device according to claim 1, wherein the amplification device (20) comprises at least one cooling device configured to cool the N amplifiers to a cryogenic temperature, for example a temperature greater than or equal to 40 K and less than or equal to 220 K.

3. The amplification device according to claim 1 or 2, wherein the temperature control device (26) is configured so that each of the N amplifiers (AMP1, AMP2, AMP3) is at a different temperature (T1, T2, T3).

4. The amplification device according to any one of the preceding claims, wherein the temperature control device is configured so that the temperature difference between at least two of the N amplifiers (AMP1, AMP2, AMP3) is greater than or equal to 10K.

5. The amplification device according to any one of the preceding claims, wherein the temperature control device (26) is configured such that each of the N amplifiers (AMP1, AMP2, AMP3) is at a temperature (T1, T2, T3) allowing a successive overlap of the passbands (BP1, BP2, BP3) of the N amplifiers (AMP1, AMP2, AMP3).

6. The amplification device according to any one of the preceding claims, wherein the temperature control device (26) comprises a temperature regulation device (28) for at least one of the N amplifiers (AMP1, AMP2, AMP3).

7. The amplification device according to any one of the preceding claims, wherein the demultiplexer (22) is configured to demultiplex the input signal (SE2) into N intermediate signals (S121, S122, S123) having bandwidths in wavelength or frequency corresponding to the passbands (BP1, BP2, BP3) of the N amplifiers (AMP1, AMP2, AMP3).

8. The amplification device according to any one of the preceding claims, wherein the temperature control device (26) comprises:
- a bar (30) made of a material having a thermal conductivity greater than or equal to 20 watts per meter-kelvin on which the N amplifiers are disposed,
- a cold spot (32) disposed at a first location on the bar, and
- a temperature regulation device (28) comprising a temperature sensor (34) disposed at a second location on the bar (30).

9. The amplification device according to any one of the preceding claims, wherein the set of N amplifiers (AMP1, AMP2, AMP3) are identical.

10. The amplification device according to any one of the preceding claims, wherein the amplifiers (AMP1, AMP2, AMP3) are optical amplifiers.

11. The amplification device according to the preceding claim, wherein the amplifiers (AMP1, AMP2, AMP3) are semiconductor optical amplifiers.

12. The amplification device according to any one of the preceding claims, wherein the temperature control device (26) is configured to control that the temperature (T1, T2, T3) of each of the N amplifiers (AMP1, AMP2, AMP3) is greater than or equal to 40 K and less than or equal to 220 K.
